# EUROPEAN PATENT APPLICATION

(11) **EP 3 751 624 A1**
(43) Date of publication of application: **16.12.2020**
(21) Application number: 19305757.7
(22) Date of filing: 13.06.2019
(51) Int. Cl.: H01L 31/042, H02S 30/10, H02S 20/23, H02S 40/36, H01L 31/048

(54) **PHOTOVOLTAIC DEVICE, ASSEMBLY AND RELATING MANUFACTURING METHOD**

(71) Applicant: TOTAL SE, 92400 Courbevoie (FR)
(72) Inventor: DEYINE, Amjad, 94300 VINCENNES (FR)
(74) Representative: Croonenbroek, Thomas Jakob

(57) **Abstract**

The invention relates to a photovoltaic device (1), comprising:
- arigid closed casing (3) having a transparent UV resistant front face (F), configured to face the sun when installed, and defining an inner space,
- at least one photovoltaic cell (5) disposed in the inner space,
- filling polymer (7), disposed in the inner space and surrounding the photovoltaic cell (5) for protection against shocks, with at least a front polymer portion (71) between the at least one photovoltaic cell (5) and the front face (F) that is transparent and UV resistant,
- reversible attaching members (35) configured to cooperate with associated reversible attaching members (35) of another associated photovoltaic device, and
- electrical terminals (9), disposed in the reversible attaching members (35), connected to the photovoltaic cell (5), and configured to come in electrical contact with associated electrical terminals (9) of another associated photovoltaic device (1).

## Description

The present invention relates to photovoltaic modules, a photovoltaic assembly and a manufacturing method of photovoltaic module.

As is known per se, a photovoltaic module comprises a plurality of photovoltaic cells (or solar cells) connected in series and/or in parallel. A photovoltaic cell is a semiconductor diode designed to absorb light energy and convert it into electrical energy.

The photovoltaic cells are generally integrated in photovoltaic modules comprising a plurality of cells integrated in or attached on a common support.

The term "photovoltaic module" is defined in the norm IEC-TS61836 as the smallest available assembly of several photovoltaic cells interconnected on a common support element. It can for example come in form of a panel, containing rows and lines of cells interconnected in series and parallel. The modules are then themselves arranged in rows and columns, and connected for example via connection cables to a converter and furthermore for example to the public grid or to local electricity networks.

In case of failure of a single cell within a module having several rows and columns of photovoltaic cells, the faulty cell will impact the performance of the whole module. However, in order to recover the initial power, the whole module comprising the faulty cell must be replaced without the possibility of repair which is quite expensive.

Furthermore, the modules have standard lengths and widths corresponding for example to a multiple of the length and width of a single photovoltaic cell. When installing the modules on a roof with a complex contour or where obstacles such as vents, skylight windows, electric transformers, air conditioning units etc. are present, potential photovoltaic surface is lost since it cannot be covered with standard size modules.

Moreover, power tuning can also only be done by adding or removing complete panels of standard size, which means that fine tuning of current or voltage is not possible.

There is therefore a need to provide a lightweight photovoltaic module that can be easily manufactured and allows an easy replacement in case of a defect cell while allowing optimized coverage of the surface of the roof or support.

In order to overcome the aforementioned drawbacks, the invention has for object a photovoltaic device, comprising:
- a rigid closed casing having a transparent UV resistant front face, configured to face the sun when installed, and defining an inner space,
- at least one photovoltaic cell disposed in the inner space,
- filling polymer, disposed in the inner space and surrounding the photovoltaic cell for protection against shocks, with at least a front polymer portion between the at least one photovoltaic cell and the front face that is transparent and UV resistant,
- reversible attaching members configured to cooperate with associated reversible attaching members of another associated photovoltaic device, and
- electrical terminals, disposed in the reversible attaching members, connected to the photovoltaic cell and configured to come in electrical contact with associated electrical terminals of another associated photovoltaic device.

The device is consequently lightweight, and easy to integrate in a photovoltaic assembly tailored to the roof or support.

The photovoltaic device may further present one or more of the following characteristics, taken separately or in combination.

The front surface of the casing may be made of transparent UV-resistant polycarbonate, polyethylene, or polymethyl methacrylate.

The whole casing may be made of transparent UV-resistant polycarbonate, polyethylene, or polymethyl methacrylate.

The transparent shock absorbing UV resistant filling polymer may comprise silicone polymers.

The casing may have a general flat shape and a rectangular top shape.

The photovoltaic cell may be a thin crystalline or polycrystalline silicon cell.

The casing may house only one or several photovoltaic cell(s).

The general shape of the cross section of the casing may have an S-form, the reversible attaching members comprising a bottom lateral appendix having a back face in flush continuity with the back face of the casing, a central part and a top lateral appendix having a front face in flush continuity with the front face of the casing, the added heights of the top and bottom lateral appendices being equal to the height of the central part and the appendices are configured to overlap with another associated photovoltaic device when assembled together.

The photovoltaic device may comprise a portion of a hook and loop fastening on its back surface, configured to attach the photovoltaic device to a roof or support comprising a complementary portion of the hook and loop fastening.

The electrical terminals may be shaped to contribute to a reversible mechanical attachment of the photovoltaic device by cooperating with electrical terminals of another photovoltaic device.

The reversible attaching members may comprise snap on forms of the casing.

The inner surface of the front face of the casing may be textured.

The front surface may be curved or inclined with respect to the back surface.

The device may comprise at least one string of multiple photovoltaic cells.

The reversible attaching members may comprise on one lateral side of the casing a protruding parallelepipedic member, and on the opposite lateral side of the casing a complementary skirt configured to encase a parallelepipedic member of another photovoltaic device.

The electrical terminals may comprise metallic ribbons, disposed on surfaces of the parallelepipedic member and of the skirt that are sensibly parallel to the front surface and come in contact with each-other when attaching photovoltaic devices, the metallic ribbons passing through holes in the lateral sides of the casing.

At least one of the parallelepipedic member and the skirt may comprise overmolded elastic material.

The invention also relates to a photovoltaic assembly characterized in that it comprises a plurality of photovoltaic devices as described above, connected mechanically and electrically by their reversible attaching members together to form strings.

The invention also relates to a method for manufacturing a photovoltaic device as described above comprising the following steps:
- providing a rigid two part casing, having an upper part forming a UV resistant transparent front face, configured to face the sun when installed, and a bottom part with side walls and integrated electrical terminals, the two parts defining an inner space when assembled, said casing, when assembled, comprising reversible attaching members configured to cooperate with associated reversible attaching members of another associated photovoltaic device
- filling partially the bottom part with a first layer of filling polymer,
- disposing at least one photovoltaic cell on the first layer of filling polymer,
- providing electrical terminals in the reversible attaching members and connecting the terminals to the photovoltaic cell,
- filling the bottom part with a second layer of transparent UV resistant filling polymer on top of the photovoltaic cell,
- closing the casing.

If the transparent UV resistant filling polymer is initially liquid, the method may comprise an additional step of curing the transparent UV resistant filling polymer.

Finally, the invention concerns a method for installing a photovoltaic assembly comprising the steps:
- mechanically and electrically connecting a plurality of photovoltaic devices as described in at least one string using their reversible attaching members,
- attaching the at least one string to a roof or support.

If the photovoltaic devices comprise, on their back surface, a portion of a hook and loop fastening, the roof or support may comprise a complementary portion of the hook and loop fastening, and the step of attaching the at least one string to a roof or support may consist in engaging the portions of the hook and loop fastening.

Other benefits and characteristics of the invention will become apparent in light of the following description, based on the figures, given in an illustrating and not limiting fashion, among which:
- Figure 1 is a schematic exploded view of a photovoltaic device according to one embodiment of the invention,
- Figure 2 is a schematic cutaway of the assembled device of figure 1,
- Figure 3 is a schematic cutaway of the reversible attaching members of devices as represented in figures 1 and 2,
- Figure 4 is a top view of the device of figures 1, 2 and 3,
- Figure 5 is a top view of several devices according to figures 1 to 3 in a photovoltaic assembly,
- Figure 6 is a schematic cut away of the devices being assembled in the photovoltaic assembly according to figure 5,
- Figure 7 is a top view of an alternative embodiment of the device of the preceding figures,
- Figures 8 and 9 show different embodiments of mechanical and electric terminals,
- Figure 10 shows an embodiment of an assembly according to another embodiment while being assembled,
- Figure 11 is a flowchart of the method to manufacture a device as described,
- Figures 12 to 16 illustrate steps of the method of figure 11,
- Figures 17a and 17b illustrate the method to obtain another embodiment of the device,
- Figure 18 illustrates a particular embodiment of a photovoltaic assembly,
- Figure 19 illustrates another embodiment of a device according to the invention,
- Figure 20 is a perspective view of another embodiment,;
- Figure 21 is an exploded view of the embodiment of figure 20,
- Figure 22 shows two devices according to the embodiment of figures 21, 22 being assembled in a photovoltaic assembly.

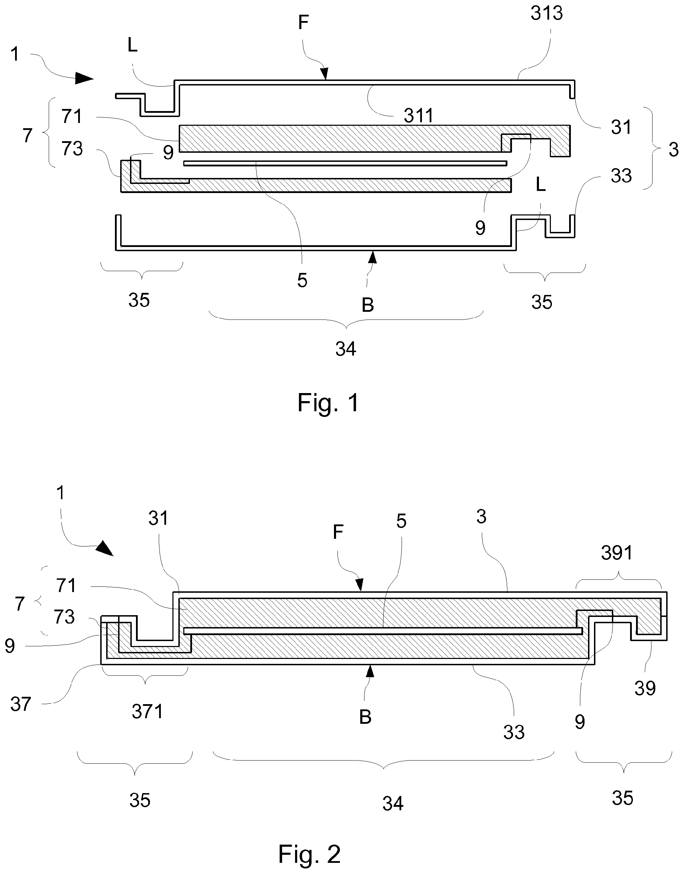

Figure 1 is a schematic representation of a photovoltaic device 1 according to one embodiment of the invention. The photovoltaic device 1 of figure 1 is represented in cutaway view and in an exploded fashion.

For orientation, the side of the photovoltaic device 1 that faces the sun, when installed, is called the front side F. The side that will face the roof or support is called the back side B. Lateral sides L are the sides perpendicular to the front F and back B sides. Adjectives such as "before", "behind" etc. are given with respect to this orientation.

Adjectives such as "above", "under" etc. are given when considering the device 1 on a flat support or roof, with its front side F on top. Heights are, unless specified otherwise, always measured perpendicularly to the front and back surfaces of the devices 1.

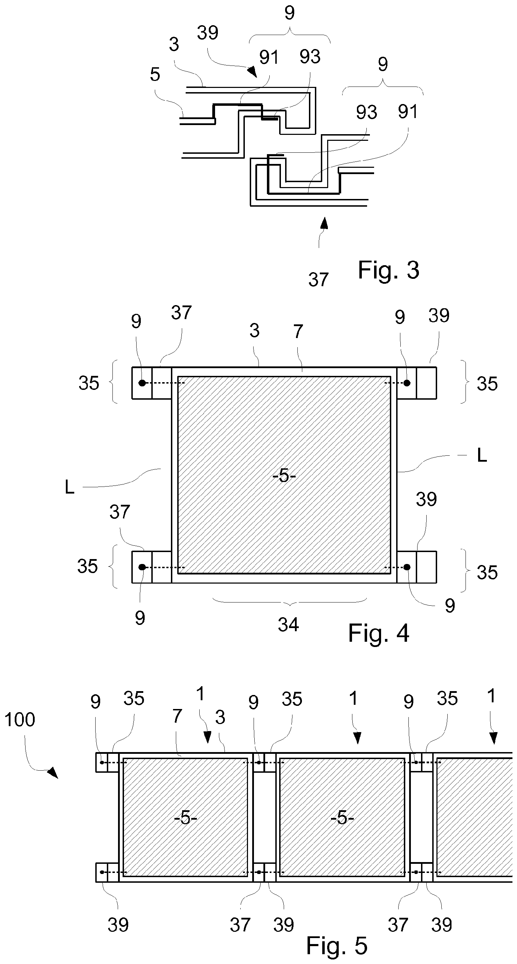

The photovoltaic device 1 of figure 1 is represented assembled in figure 2. Figure 3 shows the assembled photovoltaic device 1 viewed from above.

The photovoltaic device 1 comprises a rigid closed casing 3. The rigid casing 3 comprises essentially two parts: a front part 31 and a back part 33. The casing 3 is in particular made at least partially of transparent UV-resistant plastic material. At least the front part 31 may in particular made of transparent UV-resistant polycarbonate PC, polyethylene PE, or polymethyl methacrylate PMMA. Transparency should for example be higher than 88% in the working wavelength range for solar cells.

The back part 33 can be made of another material, not particularly chosen for its optical properties. The material for the back part 33 can be selected for its light weight, shock absorbing properties, a resistance to humidity and protection from water infiltration.

The casing 3 has a substantially flat shape, and is in particular mostly square or rectangular when viewed from above (see figure 4).

The front part 31 is the part of the casing 3 that will be facing the sun when installed, and comprises a flat front surface F. The back part 33 is the part of the casing 3 that will be facing the roof or support when installed, and comprises a flat back surface. At least one of the front and back parts 31, 33 comprises lateral walls, so as to form a basin, vessel or open container.

The inner surface 311 of the front surface F can be textured to improve light-trapping. To avoid dirt adherence, the outer surface 313 of the front surface F can be smooth or have received an anti-soiling layer or treatment.

The front surface may be slightly curved, or inclined with respect to the back surface B, to improve water flow and avoid pooling water on said front surface F. As an alternative, the whole device 1 can be elevated on one side to be inclined with respect to a horizontal support or roof on which it is implemented.

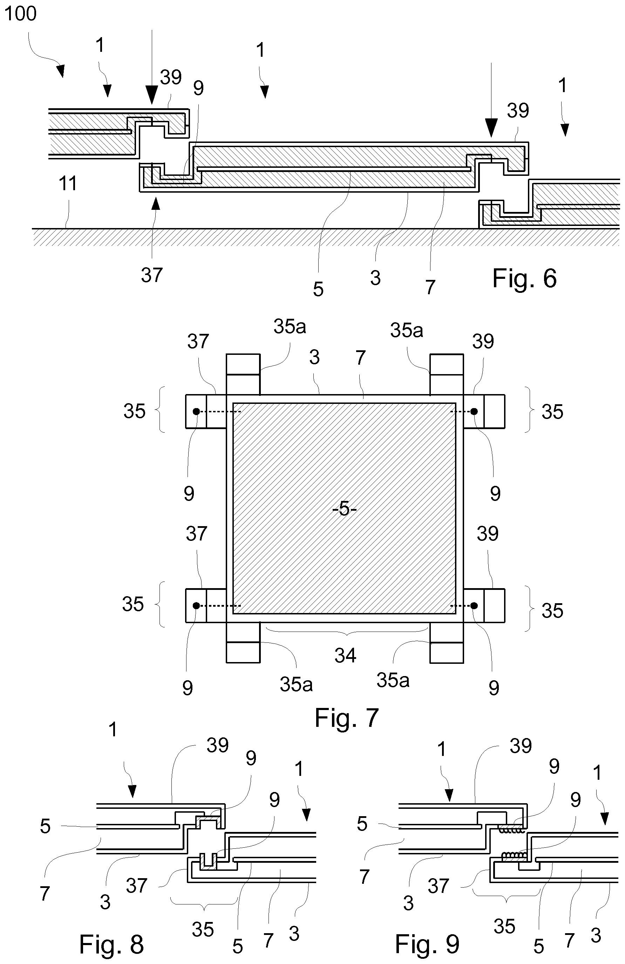

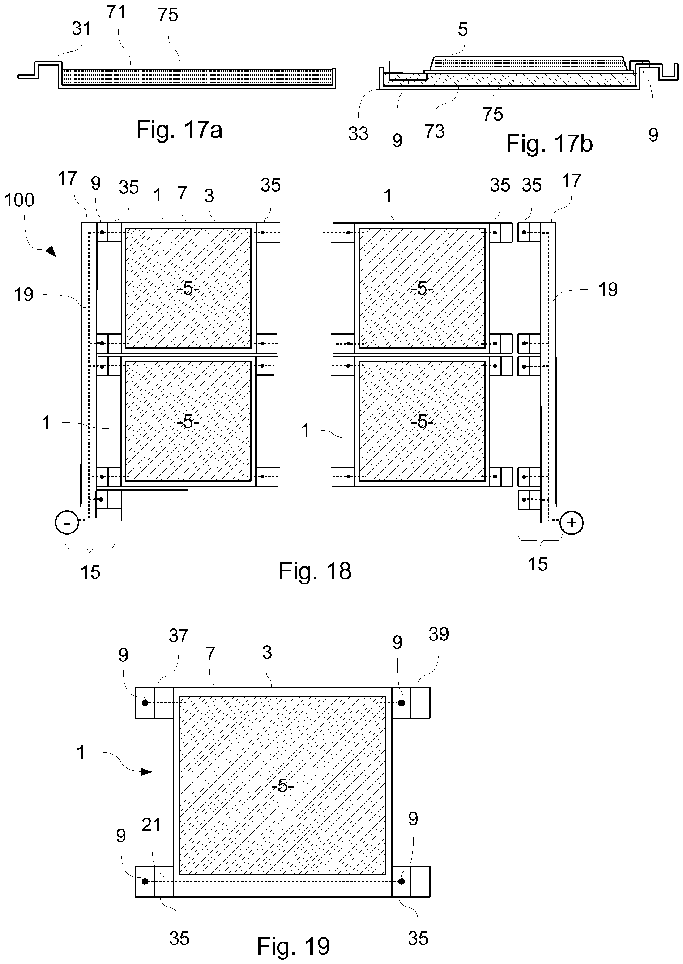

On two opposite lateral sides L of the photovoltaic device 1 (see figure 4), the casing 3 comprises extensions, forming reversible attaching members 35 configured to cooperate with associated reversible attaching members 35 of another associated photovoltaic device 1 (see figure 5 or 6) or of other elements of a photovoltaic assembly 100 containing the device 1 (e.g.: connector bodies 15 see figure 18).

The reversible attaching members 35 protrude laterally from a central portion 34 of the casing 3. The attaching members 35 are configured to cooperate with identical or corresponding / complementary reversible attaching members 35 of another associated photovoltaic device 1.

The reversible attaching members 35 give the casing a general shape in S-form in cross section (see figure 2), with a flat central portion 34. The attaching members 35 comprise here a bottom lateral appendix 37 forming the left reversible attaching members 35 in figure 2 and a top lateral appendix 39 forming the right reversible attaching members 35 in figure 2.

The top and bottom appendices 37, 39 of two neighbouring devices 1 are represented separately and about to be interlocked one with one another in figure 3.

With reference to figure 2, the bottom lateral appendix 37 has a back face 371 in flush continuity with the back face B of the back part 33 of the casing 3.

The top lateral appendix 39 has a front face 391 in flush continuity with the front face F of the front part of the casing 3.

The added heights of the top and bottom lateral appendices 37, 39 are equal to the height of the central part 34. The appendices 37 are configured to overlap with the appendices 39 of other associated photovoltaic devices 1 when assembled together in a photovoltaic assembly 100. When the appendices 37, 39 are interlocked, they consequently appear flush. The devices 1 of the assembly 100 then appear aligned, with their front surfaces F being substantially flush in this example.

In the specific example of the embodiment shown in figures 1 to 6, the appendices 37, 39 forming the reversible attaching members 35 are L-shaped in cross section, so as to interlock when the photovoltaic devices 1 are implemented in a photovoltaic assembly 100 (see figures 5 and 6) to form snap on forms of the casing 3. The reversible attaching members 35, when interlocked, provide a reversible mechanical attachment of the photovoltaic devices 1 in the photovoltaic assembly.

Other embodiments may implement for example snapping means cooperating by friction and elastic deformation, e.g. with lateral fingers and corresponding recesses, forming a socket and plug attachment.

In not represented embodiments, the reversible attaching means 35 can in particular be made of another material different to the material of the central part 34 of the casing 3, chosen for its specific mechanical properties.

The casing 3, when the front and back parts 31, 33 are assembled, encloses an inner space of essentially parallelepipedic form. In said inner space is disposed at least one, generally several photovoltaic cells 5 or a string of photovoltaic cells.

Around the photovoltaic cells 5 are disposed layers of a filling polymer 7, in particular with a UV resistant transparent polymer at least between the front surface F and the cells 5. For example, the filling polymer 7 can comprise a layer of silicone based gel that is initially liquid, with hardening materials activated by ultraviolet curing.

During curing, the filling polymer 7 is partially hardened, in particular so as to become solid, but remains soft, to absorb shocks and vibrations. The filling polymer 7 retains in particular a hardness of 30 to 70 Shores 00 in the final photovoltaic device 1.

The filling polymer 7 encapsulates and surrounds the photovoltaic cell 5, and fills almost the entirety of the inner space inside the casing 3. The softness of said filling polymer 7 protects the photovoltaic cell 5 from shocks and vibrations. Potentially harmful shocks and vibrations can for example be caused by impacts of hailstones. The filling polymer 7 then absorbs a portion of the energy of the vibrations so that the cell 5 is preserved.

The photovoltaic cells 5 can in particular be thin crystalline or polycrystalline silicon cells, with a thickness of a few hundreds of micrometres, so as to be deformable to further absorb shocks and deformation in the filling gel 7.

The volume of filling polymer 7 represented in figure 1 is separated in two portions: a front polymer portion 71 and a back polymer portion 73, situated respectively in front of and behind the photovoltaic cell 5. At least the front polymer portion 71 is transparent and UV resistant, so that sunlight reaches the cells 5.

The front polymer portion 71 and the back polymer portion 73 can be made of the same or different material. For example the back polymer portion 73 may be less transparent than the front polymer portion 71 or not transparent at all and may show better shock absorbing properties, a lighter weight, or a reduced cost.

The photovoltaic device 1 further comprises electrical terminals 9 connected to the photovoltaic cell(s) 5 in the casing 3. In the present description, "terminal" has to be understood with a broad meaning in particular as a point or connecting zone or range at which a conductor from an electrical component, device or network comes to an end and provides a point of connection to another terminal or circuit. A "terminal" may simply be the end of a wire or it may be fitted with a connector or fastener.

The electrical terminals 9 are for example attached to or maintained in position by the casing 3, in particular in the reversible attaching members 35 and configured to come in electrical contact with associated electrical terminals 9 of another associated photovoltaic device 1 in a photovoltaic assembly 100 (see figure 5) when their reversible attaching members 35 cooperate. More specifically, the electrical terminals 9 are fixed within the top and bottom lateral appendices 37, 39 of the reversible attaching members 35.

The terminals 9 of the embodiment represented in figure 3 comprise simply a bus bar or ribbon 91, with an electrical contact segment 93 protruding from the lateral appendices 37, 39 forming the attaching members 35, and attached to surfaces of the appendices 37, 39 that come in contact when assembled in a photovoltaic assembly 100.

In particular in this specific example, the protruding segment 93 of the top lateral appendix 39 is situated in the recess of the L-shape, while the protruding segment 93 of the bottom lateral appendix 37 is situated at the extremity of the L-shape. The protruding segments 93 are for example glued on the appendices 37, 39, and come into contact when the two appendices 37, 39 are interlocked to allow electrical contact.

This particular disposition further shields the terminals 9 from pooling water and rain. The lateral appendices 37, 39 can be made of a different material than the central portion 34, said different material of the lateral appendices 37, 39 being for example selected for high friction and mechanical solidity. As will be described more in detail hereafter with respect to a further embodiment, the lateral appendices may be made of or comprise a layer of an elastic material like an elastomer to provide sealing against humidity or rain water and to allow soft assembly.

As already stated, the front and back polymer portions 71, 73 may be different in function and composition. In particular, the front polymer portion 71 may comprise materials giving it high transparency, while the back polymer portion 73 may comprise materials giving it other properties (light weight, reduced price, increased shock absorption etc.).

Figure 4 shows a photovoltaic device 1 viewed from the top. The cell 5 and the casing 3 are here square, and the reversible attaching members 35 are situated in the corners of the square casing 3, with two reversible attaching members 35 on the two opposite lateral sides L. But also other shapes as square shapes may be chosen, in general rectangular shapes. Hexagons are also possible.

Figure 5 is a top view of several photovoltaic devices 1 connected in a photovoltaic assembly.

Figure 6 is a side view of a photovoltaic device 1 with two other photovoltaic devices 1 partially represented, being assembled in a photovoltaic assembly 100.

The photovoltaic devices 1 are in particular attached to each other in strings or lines by engaging their reversible attaching members 35, thus connecting their electrical terminals 9. The strings of devices 1 are then attached to a roof or support 11, for example by gluing.

To connect and attach the photovoltaic devices 1, their reversible attaching members 35 are contacted. The electrical terminals 9 then come in electrical contact, thus connecting the cells 5 for example in series.

Figure 7 shows a different embodiment of a photovoltaic device 1, with additional reversible attaching members 35a, on the two lateral sides not carrying the first reversible attaching members 35.

The additional reversible attaching members 35a are orthogonal to the first reversible attaching members 35 in the plane of the photovoltaic cell 5, and do not comprise electrical terminals 9. The first reversible attaching members 35 will be used to mechanically attach and electrically connect the devices 1 in lines. The second reversible attaching members 35a will be used to mechanically attach parallel lines of devices 1 without electrically connecting them. These optional additional reversible attaching members 35a act like spacer elements, in particular when several lines of photovoltaic devices 5 are assembled together.

Figures 8 and 9 show two alternative specific examples of embodiments of reversible attaching members 35 that may be interlocked.

In the embodiments of figures 8 and 9, the terminals 9 ensure both mechanical attachment and electrical connection, in that they contribute to the reversible mechanical attachment of the photovoltaic device 1 by cooperating with corresponding electrical terminals 9 of another photovoltaic device 1.

In figure 8, the appendices 37, 39 of the attaching members 35 are straight, and the terminals 9 comprise a snap-in fastening, with complementary parts, carried by the appendices 37 that snap-in when attached.

In figure 9, the appendices 37, 39 of the attaching members 35 are also straight, and comprise a portion of a hook and loop ("Velcro") auto-gripping, with metallic strands to ensure conductivity.

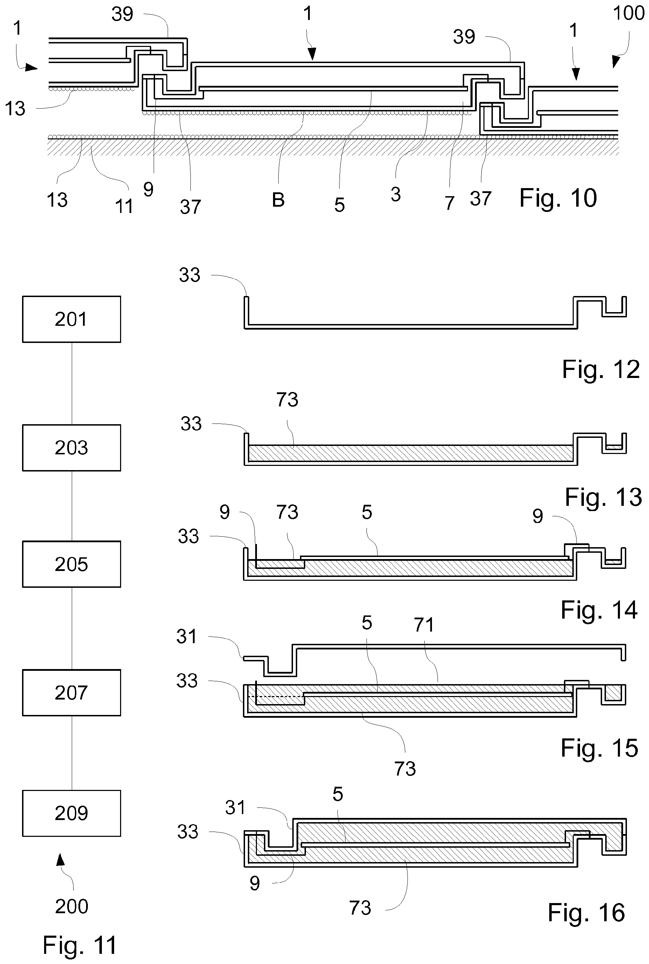

Figure 10 shows a particular embodiment of photovoltaic devices 1 being installed on a support or roof 11.

In this embodiment, the photovoltaic devices 1 comprise a portion of a hook and loop fastening 13 on its bottom side. The roof or support 11 comprises a complementary portion of the hook and loop fastening 13. Said portion of the hook and loop fastening 13 can for example come in form of a sheet that is glued, riveted or otherwise attached to the roof or support 11.

By pressing the bottom side B of the devices 1 against the roof or support 11, the hook and loop fastening 13 is engaged, and the devices 1 are then attached to the roof or support 11 in reversible fashion to form the photovoltaic assembly 100.

Figure 11 is a flowchart of an example of a method 200 to manufacture the device 1. Figures 12 to 16 illustrate the main steps of said method 200.

The first step 201 of the method 200 is the manufacturing of the casing 3. The bottom portion 33 is represented alone in figure 12.

In a second step 203, represented in figure 13, the bottom portion 33 of the casing 3 is filled with a first layer of filling polymer 7, corresponding to the back polymer portion 73. The deposited polymer 7 can be at least partially hardened or cured, for example by ultraviolet light. In particular, since the cell 5 is not yet in place, heat can be applied to the deposited polymer 7 to cure it.

If required, electrical ribbons or cables of the electrical terminals 9 can be embedded in the filling polymer 7 during this step 203, in particular before curing the deposited polymer 7.

In a third step 205, represented in figure 14, the photovoltaic cell(s) 5 is/are placed on top of the back polymer portion 73. In the case of multiple cells 5, said cells and interconnecting metallic ribbons may be disposed on a sheet, said sheet being encased in the filling polymer 7 or being only used to form a support for transfer similar to screen printing. Additional filling polymer 7 corresponding to the front polymer portion 71 is deposited over the photovoltaic cell or cells 5.

In a fourth step 207 illustrated in figure 15, the casing 3 is closed by soldering the front part 31 of the casing 3 on the back part 33, for example using ultrasound welding. The inner space is then filled with a second layer of transparent and UV resistant filling polymer 7 corresponding to the front polymer portion 71. The casing 3 may in particular comprise a blowhole and an injection hole for injecting additional polymer 7 after the casing 3 is closed, if required.

The second layer of filling polymer 7 is transparent and UV resistant to allow light to reach the cells 5, the first layer of filling polymer 7 can however be chosen from a material with other properties than transparency and UV resistance as already stated.

A fifth step 209 comprises a step of curing, in particular using UV light, of the front polymer portion 71. The obtained photovoltaic device 1 is depicted in figure 16.

According to an alternative embodiment, the method 200 can be implemented starting with the front part 31 of the casing 3, in which filling polymer 7 corresponding to the front polymer portion 71 is injected first, in symmetrical fashion to the discussed method 200 of figures 11 to 16.

Since the method 200 can be executed without applying heat to the cells 5 of the device 1, heat sensitive cells such as perovskite cells can be used.

Figures 17a and 17b illustrate steps of the method to obtain an alternative embodiment of photovoltaic device 1. In said embodiment, the front polymer portion 71 comprises layers of filling polymer 7 with different optical indexes, in particular with an increasing index when approaching the cell 5, for improved light trapping.

In figure 17a, the front part 31 of the casing 3, shaped as a basin, is turned upside-down, and filled with the filling polymer 7 in successive layers 75 with increasing optical indexes in direction of the cell 5. The layers of filling polymer 7 are deposited one after another, using for example jet printing and/or spin coating. After a layer is deposited, it is cured before another layer with an increased optical index is deposited on top.

To modify the optical index, the composition of the filling gel can be modified for each layer 75.

The front part 31 with the layer 75 of filling polymer 7 is then attached to the back part 33 with the cell 5.

In figure 17b, the layers 75 are formed directly on top of the photovoltaic cell 5, for example using jet printing. The front part 31 of the casing 3 is then put in place, with additional filling polymer 7.

Other structures, such as lenses on the peripheral portion around the cell 5 can also be made by jet printing structures with layers of varying optical index. Alternatively, the optical structures can be manufactured separately and then immersed in the front portion 71 of the filling gel 7 before curing.

To form the photovoltaic assembly 100, the photovoltaic devices 1 are attached in lines or strings. The strings of photovoltaic devices 1 are then connected to collecting devices (transformers, alternators, energy storage etc.) using connection elements 15.

Strings of devices 1 and two connection elements 15 are represented in figure 18. The connection elements 15 comprise reversible attaching members 35 with electrical terminals 9, placed along a connector body 17 and matching, in form and disposition, those of the photovoltaic devices 1. The connector body 17 is elongated and perpendicular, when installed, to the strings of photovoltaic devices 1.

The reversible attaching members 35 of the connection elements 15 cooperate with those of the photovoltaic devices 1 at the extremities of the strings.

Current collecting lines 19 run along the connector body 17, and are electrically connected to the electrical terminals 9 of the connection element 15. The strings of photovoltaic devices 1 are then connected in parallel to the collecting lines 19.

The generated electrical current is then collected in the collecting lines 19. The current is increased by adding strings in parallel, and the voltage is increased by adding additional photovoltaic devices 1 along each string.

Figure 19 shows another particular embodiment of the photovoltaic device 1, comprising an embedded return line 21. The device of figure 18 comprises four reversible attaching members 35, at the corners of the square or rectangular casing 3.

Two of the reversible attaching members 35 comprise electrical terminals 9 that are connected to contacts of the photovoltaic cell 5, and two of the reversible attaching members 35 comprise electrical terminals 9 connected by a return line 21 embedded in the filling polymer 7.

The return line 21 prevents the need of a separate return cable. Even though said return line 21 is represented besides the cell 5 in figure 18 for clarity, it can be placed under the cell 5 to improve compactness.

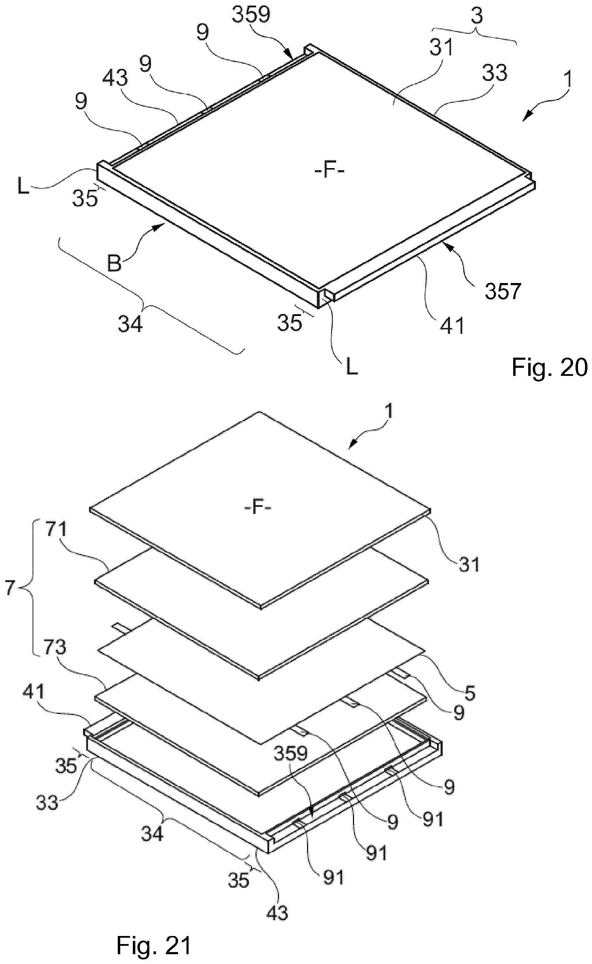

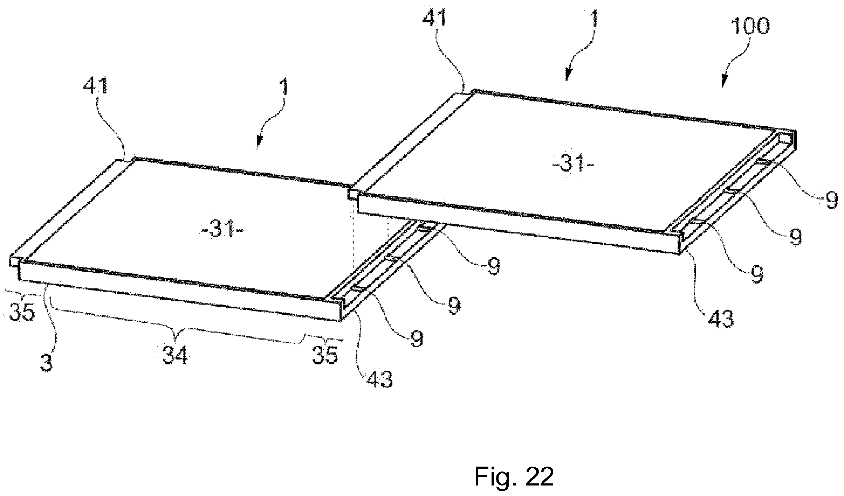

Figures 20, 21 and 22 illustrate another embodiment of the invention.

In figure 20 the photovoltaic device 1 is represented in perspective, viewed from above. The casing 3 of the device 1 comprises on two opposite lateral sides L complementary attaching members in form of a protruding parallelepipedic member 41 on one lateral side L; and a complementary skirt 43, configured to encase the parallelepipedic member 41 of a neighbouring device 1 when installed in a string of a photovoltaic assembly 100.

The skirt 43 comprises in particular three walls flushing with the lateral L and back surface B of the photovoltaic device 1.

The parallelepipedic member 41 and the skirt 43 can in particular comprise an overmolded layer of elastic polymer or elastomer, with the parallelepipedic member 41 being slightly larger than the opening in the skirt 43 (e.g. by 1 or 2%) so that when the skirt 43 encloses the parallelepipedic member 41 both are mechanically gripped by elastic deformation. Said elastic material may in particular be synthetic rubber, of the kind with high friction and/or surface treated to exhibit high friction.

The parallelepipedic member 41 and the skirt 43 comprise surfaces 357, 359 that are sensibly parallel to the front surface F, and come in contact with the corresponding surface 359, 357 of respectively the skirt 43 and parallelepipedic member 41 of another photovoltaic device 1 when the devices are assembled in a string.

Said surfaces 357, 359 carry the electrical terminals 9 that come in form of metallic ribbons, with a width of several millimetres, for example 2 to 5mm. When the parallelepipedic member 41 and the skirt 43 are mechanically gripped, the electrical terminals 9 are protected from rainwater.

Figure 21 is an exploded view of the photovoltaic device of figure 20.

The photovoltaic device comprises a photovoltaic cell 5, encapsulated in filling polymer 7, in particular between a front portion 71 and a back portion 73 of said polymer 7.

The photovoltaic cell 5 and the polymer 7 are placed in a casing 3, comprising an upper part 31 and a bottom part 33. The upper part 31 is here in particular shaped like a flat plate, made of transparent polycarbonate, in particular crystal polycarbonate of high transparency, and corresponds to the front surface F.

The bottom part 33 forms a basin of parallelepipedic shape, with a flat bottom and lateral walls so as to contain the cell 5 and filling polymer 7. Two opposite lateral walls of said bottom part 33 carry on their outer lateral surfaces L the parallelepipedic member 41 and the skirt 43.

The metallic ribbons extend from the cell 5. The lateral side L carrying the parallelepipedic member 41 and the skirt 43 comprise holes 91 shaped so that the metallic ribbons forming the electrical terminals 9 can be inserted through said holes 91.

The holes are in the example of the figures continued as grooves on the surfaces 357, 359 carrying the electrical terminals 9 so that said electrical terminals 9 are flush with the surfaces 357, 359 they are disposed on. The filling polymer 7 can be selected with a viscosity preventing leakage through said holes 91 during assembly, while when cured the filling polymer 7 will close the holes 91. The assemblies 100 according to the invention are easy to manufacture and install, and require no particular tools or additional cables during installation. The connections between the devices 1 are also protected from the weather. In particular, it is possible to reduce the number of cells 5 per device 1, up to one cell 5 per device 1, so that to change a faulty cell 5 only a limited number of still functional cells 5 have to be replaced by replacing a complete device 1.

## Claims

1. Photovoltaic device (1), comprising:
- a rigid closed casing (3) having a transparent UV resistant front face (F), configured to face the sun when installed, and defining an inner space,
- at least one photovoltaic cell (5) disposed in the inner space,
- filling polymer (7), disposed in the inner space and surrounding the photovoltaic cell (5) for protection against shocks, with at least a front polymer portion (71) between the at least one photovoltaic cell (5) and the front face (F) that is transparent and UV resistant,
- reversible attaching members (35) configured to cooperate with associated reversible attaching members (35) of another associated photovoltaic device, and
- electrical terminals (9), disposed in the reversible attaching members (35), connected to the photovoltaic cell (5), and configured to come in electrical contact with associated electrical terminals (9) of another associated photovoltaic device (1).

2. Photovoltaic device (1) according to claim 1, **characterized in that** the transparent shock absorbing UV resistant filling polymer (7) comprises silicone polymers.

3. Photovoltaic device (1) according to any of the precedent claims, **characterized in that** the photovoltaic cell (5) is a thin crystalline or polycrystalline silicon cell.

4. Photovoltaic device (1) according to any of the preceding claims, **characterized in that** it comprises a portion of a hook and loop fastening (13) on its back surface (B), configured to attach the photovoltaic device to a roof or support (11) comprising a complementary portion of the hook and loop fastening (13).

5. Photovoltaic device (1) according to any of the preceding claims, **characterized in that** the reversible attaching members (35) comprise snap on forms of the casing.

6. Photovoltaic device (1) according to any of the preceding claims, **characterized in that** the inner surface (311) of the front face (F) of the casing (3) is textured.

7. Photovoltaic device (1) according to any of claims 1 to 4, **characterized in that** the reversible attaching members (35) comprise on one lateral side (L) of the casing (3) a protruding parallelepipedic member (41), and on the opposite lateral side (L) of the casing (3) a complementary skirt (43) configured to encase a parallelepipedic member (41) of another photovoltaic device (1).

8. Photovoltaic device (1) according to claim 7, **characterized in that** the electrical terminals (9) comprise metallic ribbons, disposed on surfaces (357, 359) of the parallelepipedic member (41) and of the skirt (43) that are sensibly parallel to the front surface (F) and come in contact with each-other when attaching the photovoltaic devices (1), the metallic ribbons passing through holes (91) in the lateral sides (L) of the casing (3).

9. Photovoltaic device (1) according to claim 7 or 8, **characterized in that** the at least one of the parallelepipedic member (41) and the skirt (43) comprises overmolded elastic material.

10. Photovoltaic assembly (100), **characterized in that** it comprises a plurality of photovoltaic devices according to any of the preceding claims connected mechanically and electrically by their reversible attaching members (35) together to form strings.

11. Method (200) for manufacturing a photovoltaic device (1) according any of claims 1 to 9 comprising the steps:
- providing a rigid two part casing, having an upper part forming a UV resistant transparent front face (F), configured to face the sun when installed, and a bottom part with side walls and integrated electrical terminals (9), the two parts defining an inner space when assembled, said casing, when assembled, comprising reversible attaching members configured to cooperate with associated reversible attaching members of another associated photovoltaic device
- filling partially the bottom part with a first layer of filling polymer,
- disposing at least one photovoltaic cell (5) on the first layer of filling polymer,
- providing electrical terminals (9) in the reversible attaching members (35) and connecting the terminals (9) to the photovoltaic cell (5),
- filling the bottom part with a second layer of transparent UV resistant filling polymer on top of the photovoltaic cell (5),
- closing the casing (3).

12. Method for manufacturing a photovoltaic device (1) according to claim 11, **characterized in that** the transparent UV resistant filling polymer is initially liquid and **in that** it comprises an additional step of curing the transparent UV resistant filling polymer.

13. Method for installing a photovoltaic assembly comprising the steps :
- mechanically and electrically connecting a plurality of photovoltaic devices (1) according to claim 1 to 16 in at least one string using their reversible attaching members (35),
- attaching the at least one string to a roof or support (11).

14. Method according to claim 13, wherein the photovoltaic devices (1) comprise, on their back surface (B), a portion of a hook and loop fastening (13), and the roof or support (11) comprises a complementary portion of the hook and loop fastening (13), and wherein the step of attaching the at least one string to a roof or support (11) consists in engaging the portions of the hook and loop fastening (13).
